# EUROPEAN PATENT SPECIFICATION

(11) **EP 1 130 720 B1**
(45) Date of publication and mention of the grant of the patent: **06.04.2005**
(21) Application number: 00931712.4
(22) Date of filing: 06.06.2000
(51) Int. Cl.: H01S 5/183

(54) **SURFACE-EMISSION SEMICONDUCTOR LASER**
OBERFLÄCHENEMITTIERENDER HALBLEITERLASER
LASER A SEMI-CONDUCTEUR A EMISSION PAR LA SURFACE

(30) Priority: 13.09.1999 JP 25906799
(43) Date of publication of application: 05.09.2001
(73) Proprietor: THE FURUKAWA ELECTRIC CO., LTD., Tokyo 100-8322 (JP)
(72) Inventor: YOKOUCHI, Noriyuki, c/o The Furukawa Elec. Co.,, Tokyo 100-8322 (JP); KASUKAWA, Akihiko, c/o The Furukawa Electric Co.,, Tokyo 100-8322 (JP)
(74) Representative: Modiano, Guido, Dr.-Ing.
(86) International application number: PCT/JP2000/003668
(87) International publication number: WO 2001/020734

(56) References cited:
- JP-A- 4 318 992
- JP-A- 6 181 364
- JP-A- 8 340 156
- JP-A- 9 260 764
- JP-A- 11 068 225
- US-A- 5 317 587
- US-A- 5 412 680
- US-A- 5 493 577
- SHINADA S ET AL: "Micro-aperture surface emitting laser for near field optical data storage" LASERS AND ELECTRO-OPTICS, 1999. CLEO/PACIFIC RIM '99. THE PACIFIC RIM CONFERENCE ON SEOUL, SOUTH KOREA 30 AUG.-3 SEPT. 1999, PISCATAWAY, NJ, USA,IEEE, US, 30 August 1999 (1999-08-30), pages 618-619, XP010364559 ISBN: 0-7803-5661-6
- RANDALL S. GEELS ET AL.: 'InGaAs vertical-cavity surface-emitting lasers' IEEE JOURNAL OF QUANTUM ELECTRONICS vol. 27, no. 6, 1991, pages 1359 - 1367, XP002931267
- KENICHI IGA: 'Menhakkou laser' TRANSACTIONS OF THE INSTITUTE OF ELECTRONICS, INFORMATION AND COMMUNICATION ENGINEERS vol. J81-C-1, no. 9, September 1998, pages 483 - 493, XP002937382

## Description

### TECHNICAL FIELD

The present invention relates to a surface emitting semiconductor laser device, and, more particularly, to a surface emitting semiconductor laser device capable of controlling the transverse modes of an oscillating laser beam.

### BACKGROUND ART

Recently have been in progress studies to realize the construction of large-capacity optical communications networks and the construction of optical data communications systems, such as optical interconnection and optical computing. Attention is being paid to surface emitting semiconductor laser devices which are fabricated by using a GaAs substrate as their light sources.

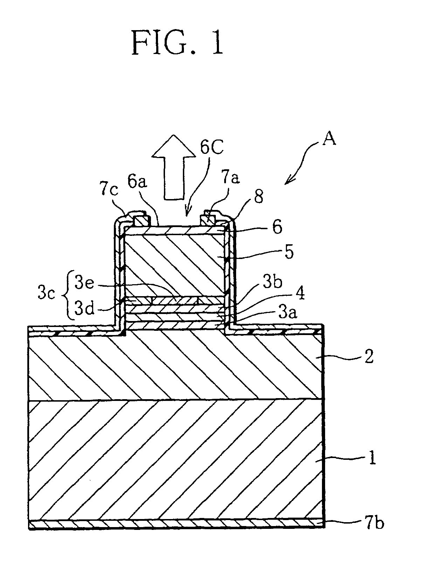

Fig. 1 shows one example A of the basic layer structure of such a surface emitting laser device.

In this device A, a lower reflector layer structure 2 which is the lamination of alternate thin layers of, for example, n-type AlGaAs, that have different compositions is formed on a substrate 1 made of, for example, n-type GaAs. Formed in order on this lower reflector layer structure 2 are a lower clad layer 3a of, for example, i-type AlGaAs, a light-emitting layer 4 having a quantum well structure formed of GaAs/AlGaAs, and an upper clad layer 3b of i-type AlGaAs. Formed on this upper clad layer 3b is an upper reflector layer structure 5 which is the lamination of alternate thin layers of, for example, p-type AlGaAs, that have different compositions. Then, a p-type GaAs layer 6 is formed on the topmost surface of the upper reflector layer structure 5, thereby completing the entire layer structure. This layer structure is etched out to at least the top surface of the lower reflector layer structure 2 and a columnar structure is formed in the center portion.

An upper electrode 7a of, for example, AuZn having an annular ring shape is formed in the vicinity of the peripheral portion of the top surface of the GaAs layer 6 in the columnar structure located in the center. A lower electrode 7b of, for example, AuGeNi/Au is formed on the back surface of the substrate 1.

The side surfaces of the columnar structure in the entire surface and that peripheral portion of the surface of the GaAs layer 6 which is located outside the upper electrode 7a are coated with a dielectric film 8 of, for example, Si₃N₄, so that a partial surface 6a of the GaAs layer 6 or the inner portion of the upper electrode 7a becomes a circular opening portion 6C which serves as a beam-emerging window for the laser beam. The surfaces of the upper electrode 7a and the dielectric film 8 are covered with a layer of, for example, Ti/Pt/Au, thereby forming an electrode lead pad 7c of Ti/Pt/Au.

In this laser device A, the lowermost layer of the upper reflector layer structure 5 or a layer 3c which is located closest to the light-emitting layer 4 is formed of, for example, p-type AlAs. The outer peripheral portion of this AlAs layer 3c is an insulating region 3d having a planar shape of an annular ring and essentially consisting of Al₂O₃ formed by selectively oxidizing only the AlAs layer. This forms a current constriction structure for the light-emitting layer 4.

As the upper electrode 7a and the lower electrode 7b of this laser device A operate, laser oscillation occurs in the light-emitting layer 4 and the laser beam passes through the GaAs layer 6 and oscillates upward perpendicular to the substrate 1 from the surface portion 6a (the laser-beam-emerging window) as indicated by the arrow.

To incorporate a surface emitting semiconductor laser device as the light source of an optical transmission system, it is necessary to control the transverse modes of the laser beam that is emitted from the laser device.

Data linking using multimode optical fibers, for example, requires as a light source a laser device which stably oscillates in high-order transverse mode. An inter-board optical transmission system which employs spatial propagation and fast optical transmission system which uses single-mode optical fibers require as a light source a laser device which oscillates in fundamental transverse mode.

Conventionally, the transverse modes of the surface emitting semiconductor laser device with the above-described structure are controlled by adjusting the dimension of the current constriction structure as shown in Fig. 1. Specifically, this control is carried out by changing the width of the annular ring of the annular-ring shaped insulating region 3d which changes the dimensions of a current feeding passage 3e having a circular planar shape located in the center portion. For example, the laser device that oscillates in fundamental transverse mode requires that the diameter of the current feeding passage 3e should be equal to or smaller than about 5 µm.

Designing the diameter of the current feeding passage 3e to such a small value eventually increases the resistance of the laser device, thus undesirably requiring a higher operation voltage.

Precise control of the diameter of the current feeding passage 3e in the order of µm means accurate control of the width of the insulating region 3d, i.e., the oxidation width of the AlAs layer 3c. It is however very hard to control the oxidation width in the order of µm. This is likely to result in a variation in the characteristics of fabricated laser devices, which raises a problem in the reproducibility.

In the case of the laser device that oscillates in multimodes, increasing the diameter of the current feeding passage generates noise caused by switching of the transverse modes at the time of feeding the current, thus degrading the optical transmission characteristics.

A conventional surface emitting laser is disclosed in paper Th04 by S. Shinada et al., "A micro-aperture surface emitting laser for near field optical data storage", Conference on Lasers and Electro-Optics 1999, 30. Aug. - 03. Sept. 1999, pages 618 - 619, Seoul, South Korea.

Accordingly, it is an object of the present invention to provide a surface emitting semiconductor laser device which has a novel transverse mode control mechanism that can overcome the aforementioned problems of the conventional surface emitting semiconductor laser devices and which is fabricated more easily than the conventional ones.

### DISCLOSURE OF THE INVENTION

To achieve the above object, according to the present invention, there is provided, a surface emitting semiconductor laser device comprising a substrate; a layer structure of a semiconductor material formed on the substrate and having a light-emitting layer provided between an upper reflector layer structure and a lower reflector layer structure; an upper electrode having a planar shape of an annular ring formed above the upper reflector layer structure and having an opening portion defined inside; and a transparent layer transparent to an oscillation laser beam and covering a part of a surface of the opening portion.

It is preferable that the transparent layer be comprised of at least one layer of a dielectric film. It is also preferable that a current feeding passage should be formed in the vicinity of the light-emitting layer and the forming position of the transparent layer formed at the opening portion should be included in the planar shape of the current feeding passage. In the surface emitting semiconductor laser device, the thickness of the transparent layer may be equivalent to (2i + 1)/4n times the oscillation wavelength of the oscillating laser beam where n is the refractive index of the transparent layer and i is an integer. Alternatively, it is provided the surface emitting semiconductor laser device having a metal film formed on the transparent layer, in which the thickness of the transparent layer may be equivalent to 2i/4n times the oscillation wavelength of the oscillating laser beam where n is the refractive index of the transparent layer and i is a natural number.

### BRIEF DESCRIPTION OF THE DRAWINGS

Fig. 1 is a cross-sectional view showing an example A of a conventional surface emitting semiconductor laser device;
Fig. 2 is a cross-sectional view showing an example B1 of a surface emitting semiconductor laser device according to the present invention;
Fig. 3 is a cross-sectional view showing another example B2 of the surface emitting semiconductor laser device according to the present invention;
Fig. 4 is a cross-sectional view illustrating an Si₃N₄ film and a resist mask being formed on a layer structure formed on a substrate;
Fig. 5 is a cross-sectional view depicting a columnar structure formed on the substrate;
Fig. 6 is a cross-sectional view depicting a state after the columnar structure in Fig. 5 is subjected to oxidation treatment;
Fig. 7 is a cross-sectional view illustrating an upper electrode and a dielectric film being formed on the structure shown in Fig. 6;
Fig. 8 is a graph showing the current-voltage characteristics and current-optical output characteristics of Example 1 and Comparative example 1;
Fig. 9 is a graph showing the current-voltage characteristics and current-optical output characteristics of Examples 2 and 3 and Comparative example 2;
Fig. 10 shows near-field patterns of Examples 2 and 3 and Comparative example 2 when the operation current is 7 mA; and
Fig. 11 shows near-field patterns of Examples 2 and 3 and Comparative example 2 when the operation current is 15 mA.

### BEST MODE OF CARRYING OUT THE INVENTION

A surface emitting semiconductor laser device according to the present invention is contrived on the technical concept of controlling the transverse modes by reducing the reflectance of that portion of the opening-portion formed at upper reflector layer structure where laser oscillation is not intended (i.e., by causing multiple reflections in that portion). To achieve this technical concept, a layer transparent to the oscillation wavelength of an oscillating laser beam (hereinafter simply referred to as "transparent layer") is provided on a part of the surface of the opening portion that serves as a beam-emerging window for the laser beam.

The transparent layer can be formed of various kinds of materials in association with the oscillation wavelength of the laser beam. A preferable example of this transparent layer is a dielectric film comprised of a typical dielectric, such as silicon nitride, silicon oxide, aluminum oxide, titanium oxide, magnesium oxide or magnesium fluoride. The transparent layer may also be formed of ITO (Indium-Tin oxide). With ITO used, this transparent layer can serve as an electrode. It is to be noted that the dielectric film may have a single-layer structure or a lamination structure consisting of two or more layers.

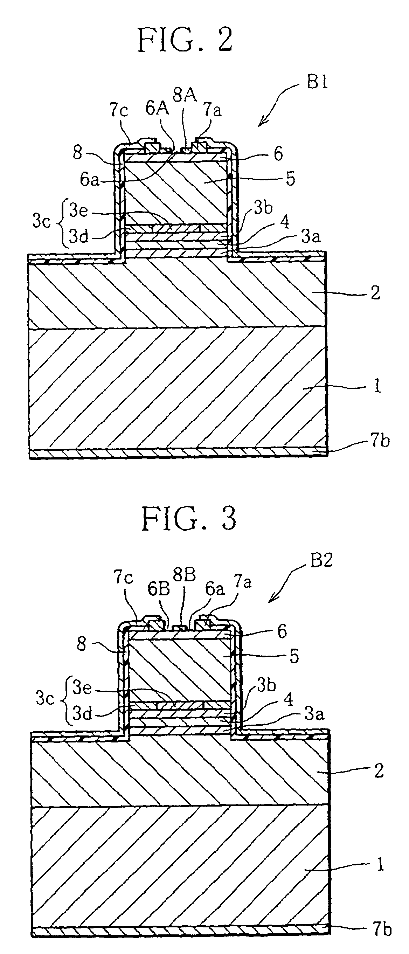

A surface emitting semiconductor laser device according to the present invention will now be discussed of the case where the transparent layer is a dielectric film referring to the accompanying drawings. Fig. 2 shows an example B1 of the surface emitting semiconductor laser device of the present invention, and Fig. 3 shows another example B2 thereof.

The layer structures of those devices B1 and B2 are the same as that of the device A shown in Fig. 1, with an exception in that a dielectric film is also formed on the surface of the opening portion 6C which serves as the aforementioned laser-beam-emerging window 6a of the device A so that the planar shape of the laser-beam-emerging windows of the devices B1 and B2 differ from that in Fig. 1.

In the device B1, a dielectric film 8A having a planar shape of an annular ring is formed at the opening portion which is located inside an upper electrode 7a, thereby forming a new beam-emerging window 6A of a smaller diameter which has a circular planar shape.

In the device B2, a dielectric film 8B having a circular planar shape is formed at the center portion of a GaAs layer 6 which is exposed through the opening portion 6C, thereby forming a new beam-emerging window 6B which has a planar shape of an annular ring.

It is preferable that the thickness of the dielectric film 8A (8B) be approximately a value of λ x (2i + 1)/4n where X is the oscillation wavelength of the laser beam emitted by the device B1 (B2), n is the refractive index of the dielectric that is the material for the dielectric film 8A (8B) and i is an integer, such as 0, 1, 2 or the like.

When the dielectric film 8A (8B) having the aforementioned planar shape and thickness is formed on the topmost surface, the effective reflectance of the upper reflector layer structure that is located directly below the dielectric film 8A (8B) decreases. As a result, laser oscillation does not occur only directly under the dielectric film 8A (8B), so that the transverse modes are controlled.

The planar shape of this dielectric film is not limited to those mentioned above, but may be changed any desirable shape.

It is preferable that the dielectric film is formed with a thickness of λx 2i/4n, and a metal film of Au, Ti, Cr or the like be formed on the dielectric film, because the metal film enhances the effect of reducing the reflectance so that control of the transverse modes of the laser beam is demonstrated more effectively.

As the dielectric film (transparent layer) formed at the opening portion 6C demonstrates the aforementioned effect, it is desirable that the forming position of the dielectric film is included in the planar shape of the current feeding passage 3e that regulates the laser oscillation in a light-emitting layer 4. This is because the design surely reduces the effective reflectance of the upper reflector layer structure 5 located directly under the dielectric film with respect to the laser beam which oscillates through the current feeding passage 3e, thereby improving the reliability of the control of the transverse modes.

### Examples

### (1) Structures of laser devices

The laser device shown in Fig. 2 was fabricated in the following manner. Note that the oscillation wavelength of this laser device is designed to be 850 nm.

A thin layer of n-type Al_{0.2}Ga_{0.8}As with a thickness of 40 nm and a thin layer of n-type Al_{0.9}Ga_{0.1}As with a thickness of 50 nm were alternately laminated on an n-type GaAs substrate 1 by MOCVD with a composition twisted layer of a thickness of 20 nm intervened at each interface of the heterojunction of both thin layers, thus forming a lower reflector layer structure 2 having 30.5 pairs of multiple layers. Then, a lower clad layer 3a (thickness of 97 nm) of non-doped Al_{0.3}Ga_{0.7}As, a light-emitting layer 4 with a quantum well structure, which comprises a 3-layer GaAs quantum well layer (each layer having a thickness of 7 nm) and a 4-layer Al_{0.2}Ga_{0.8}As barrier layer (each layer having a thickness of 8 nm) and an upper clad layer 3b (thickness of 97 nm) of non-doped Al_{0.3} Ga_{0.7}As were stacked in order on the lower reflector layer structure 2. Then, a thin layer of p-type Al_{0.2}Ga_{0.8}As with a thickness of 40 nm and a thin layer of p-type Al_{0.8}Ga_{0.2}As with a thickness of 50 nm were alternately laminated on the resultant structure with a composition twisted layer of a thickness of 20 nm intervened at each interface of the heterojunction of both thin layers, thus forming an upper reflector layer structure 5 having 25 pairs of multiple layers.

Then, a p-type GaAs layer 6 was stacked on the topmost layer, the p-type Al_{0.2}Ga_{0.8}As layer, of the upper reflector layer structure 5.

The lowermost layer 3c of the upper reflector layer structure 5 was formed of p-type AlAs with a thickness of 50 nm.

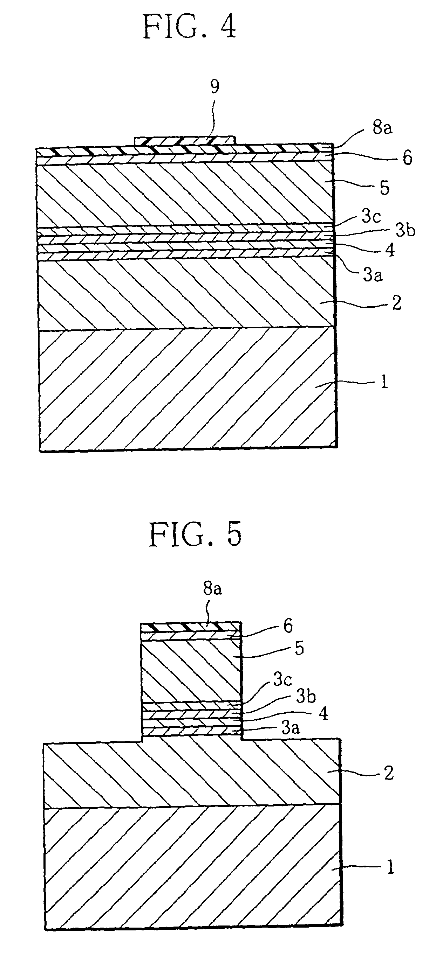

Next, an Si₃N₄ film 8a was formed on the surface of the p-type GaAs layer 6 in the layer structure by plasma CVD, and a circular resist mask 9 having a diameter of about 45 µm was formed on the Si₃N₄ film 8a by photolithography using an ordinary photoresist (Fig. 4).

Then, the Si₃N₄ film 8a excluding the part lying directly under the resist mask 9 was etched out by RIE using CF₄, after which the resist mask 9 was entirely removed, thus exposing the surface of the GaAs layer 6 which has a planar shape of an annular ring.

Then, with the Si₃N₄ film 8a used as a mask, etching to the lower reflector layer structure 2 was carried out using an etchant which is a mixture of phosphoric acid, hydrogen peroxide and water, thus forming a columnar structure (Fig. 5).

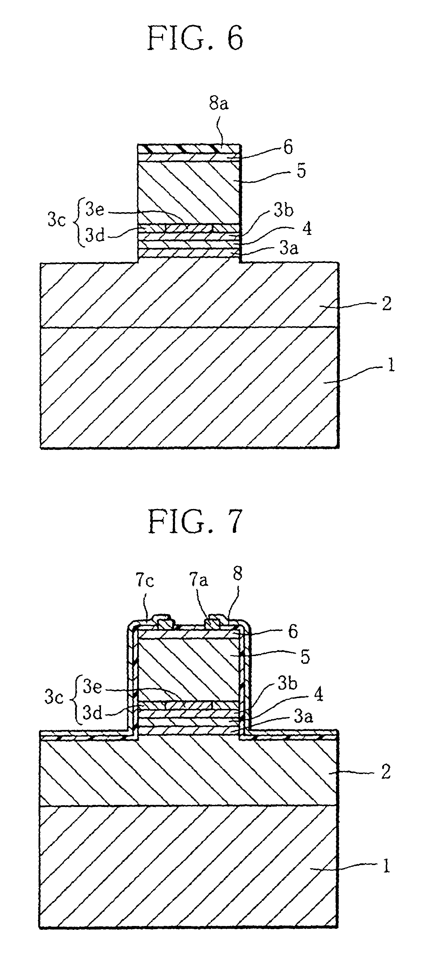

Then, this columnar structure was heated at 400°C for about 25 minutes in the atmosphere of water vapor. Only the outer peripheral portion of the p-type AlAs layer 3c was selectively oxidized into an annular ring shape, forming a current feeding passage 3e with a diameter of about 15 µm in the center portion (Fig. 6).

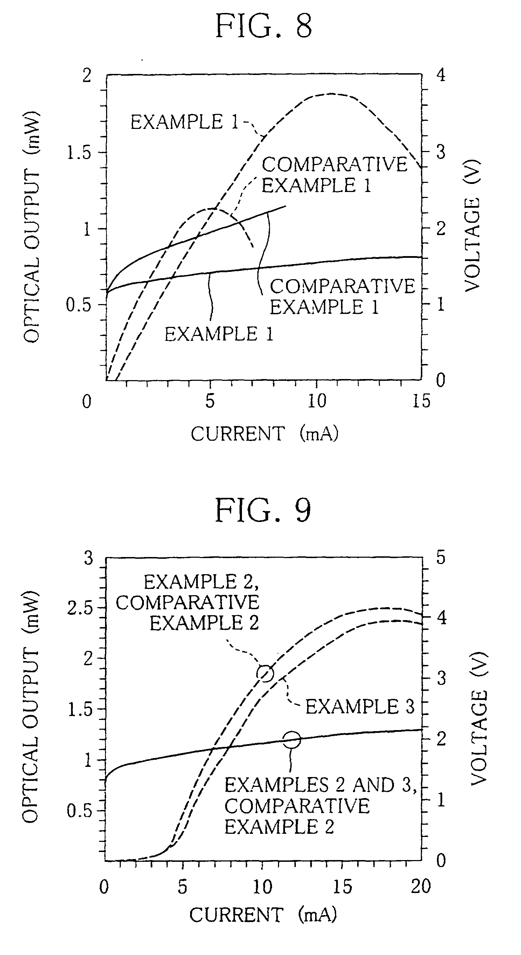

Next, the Si₃N₄ film 8a was completely removed by RIE, and the entire surface was coated with an Si₃N₄ film 8 by plasma CVD. Then, the Si₃N₄ film 8 formed on the top surface of the GaAs layer 6 with a diameter of about 35 µm was removed in an annular ring shape having an outside diameter of 25 µm and an inside diameter of 15 µm, thus exposing the surface of the GaAs layer 6. AuZn was then vapor-deposited on the exposed surface to form an upper electrode 7a having an annular ring shape. Then, only the outside surface of the upper electrode 7A was coated with an Si₃N₄ film 8 on which a pad 7c for an electrode lead was formed of Ti/Pt/Au (Fig. 7).

The thickness of the Si₃N₄ film 8 then was set to 121 nm, a value acquired for i = 0 in the aforementioned equation of λ x (2i + 1)/4n, because the refractive index of Si₃N₄ was 1.75 and the oscillation wavelength of the device was 850 nm.

Next, photolithography and RIE were performed on the Si₃N₄ film located inside the upper electrode 7a to bore a small circular hole with a diameter of 6 µm in the center portion, thus exposing the surface of the GaAs layer 6 with the other Si₃N₄ film 8A remaining. As a result, a beam-emerging window 6A was formed, thus completing the device B1 shown in Fig. 2. This is designated as Example 1.

In another example, the beam-emerging window 6A was formed by setting the diameter of the small hole to 10 µm. This is designated as Example 2.

A portion 8B with a diameter of 6 µm was left at the center portion of the Si₃N₄ film located inside the upper electrode 7a and the other portion of the Si₃N₄ film was entirely removed, thus forming a beam-emerging window 6B having an annular ring shape with an outside diameter of 15 µm and an inside diameter of 6 µm. This completed the device B2 shown in Fig. 3. This device is designated as Example 3.

In the device of any of Examples, the back of the substrate 1 was polished so that the entire substrate 1 had a thickness of approximately 100 µm and AuGeNi/Au was vapor-deposited on the polished surface, thus forming the lower electrode 7b.

For comparison, with the oxidation time for the AlAs layer 3c set to approximately 30 minutes, the oxidation width of the AlAs layer 3c was increased to set the diameter of the current feeding passage 3e to about 5 µm and the opening portion 6C with a diameter of 15 µm was formed in the GaAs layer 6, fabricating the device A shown in Fig. 1 in which this opening portion 6C served as the beam-emerging window 6a. This device is designated as Comparative example 1. In the device of Example 1, the whole Si₃N₄ film located inside the upper electrode 7a was removed to form an opening portion with a diameter of 15 µm, fabricating the device A in which this opening portion served as the beam-emerging window 6a. This device is designated as Comparative example 2.

Table 1 below shows the dimensions of the current feeding passages and the dimensions and shapes of the beam-emerging windows of the above five types of devices.

**Table 1**

| | Diameter of columnar structure (µm) | Dimension of upper electrode | | Diameter of current feeding passage (µm) | Shape of beam-emerging window |
|---|---|---|---|---|---|
| | | Inside diameter (µm) | Outside diameter (µm) | | |
| Example 1 | 35 | 15 | 25 | 15 | Circle of 6 µm in diameter |
| Example 2 | 35 | 15 | 25 | 15 | Circle of 10 µm in diameter |
| Example 3 | 35 | 15 | 25 | 15 | Annular ring with outside diameter of 15 µm inside diameter of 6 µm |
| Comparative Example 1 | 35 | 15 | 25 | 5 | Circle of 15 µm in diameter |
| Comparative Example 2 | 35 | 15 | 25 | 15 | Circle of 15 µm in diameter |

### (2) Evaluation of characteristics of laser devices

1) Fig. 8 shows the current-voltage characteristics and current-optical output characteristics of Example 1 and Comparative example 1. In this diagram, the solid lines represent the current-voltage characteristics and the broken lines represent the current-optical output characteristics.

In both Example 1 and Comparative example 1, oscillation takes place in the fundamental transverse modes.

As apparent from Fig. 8, Example 1 has a lower operation voltage than Comparative example 1; for example, the former operation voltage is about 1.8 V at 5 mA which is considerably lower than the operation voltage of 2.4 V of Comparative example 1. This is because the diameter of the current feeding passage of Example 1 is 15 µm, making the resistance there lower than the current feeding passage of Comparative example 1 which has a diameter of 5 µm.

With regard to the current-optical output characteristics, the optical output of Example 1 is increasing without saturation until the current becomes about 10 mA even though the threshold current is slightly high as compared with that of Comparative example 1. This seems to have resulted from the effect of suppressing the heat generation due to the low resistance in the vicinity of the current feeding passage.

2) Fig. 9 shows the current-voltage characteristics and current-optical output characteristics of Examples 2 and 3 and Comparative example 2. In this diagram, the solid lines represent the current-voltage characteristics and the broken lines represent the current-optical output characteristics.

As apparent from Fig. 9, no significant differences in both characteristics among Examples 2 and 3 and Comparative example 2 are seen.

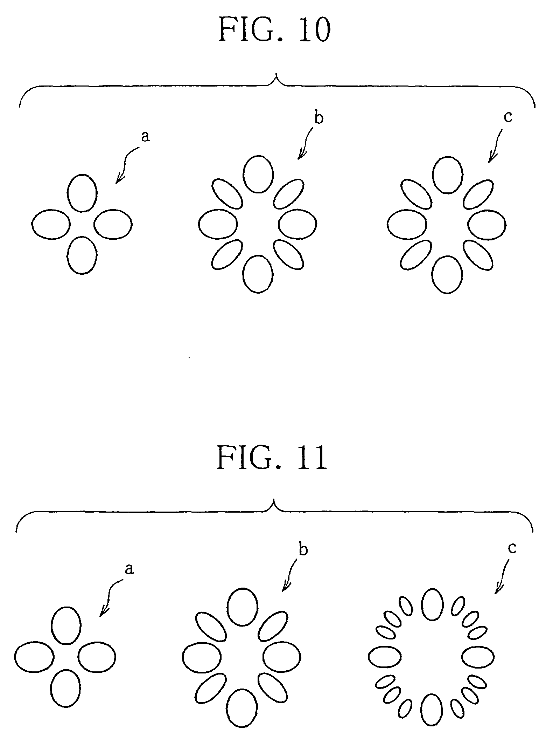

The near-field patterns for the devices of Examples 2 and 3 and Comparative example 2 were observed. Fig. 10 shows the results of the observation with the operation current of 7 mA, and Fig. 11 shows the results of the observation with the operation current of 15 mA.

In Figs. 10 and 11, a pattern a is for Example 2, a pattern b is for Example 3 and a pattern c is for Comparative example 2.

As apparent from Figs. 10 and 11, the pattern c for Comparative example shows multiple emission spots at the peripheral portion, which are switched by the feeding of the current. In the case of the pattern a of Example 2, there are fewer emission spots which are concentrated at the center portion. Even increasing the amount of current fed did not cause any switching action in the latter case.

In the case of the pattern b of Example 3, the number of emission spots becomes greater than that of Example 2. What is more, the entire emission spots are scattered. Increasing the amount of current fed did not cause any switching action in the case of Example 3 either.

### INDUSTRIAL APPLICABILITY

As apparent from the above description, the laser device of the present invention is a surface emitting semiconductor laser device capable of controlling the transverse modes, for example, a laser device which oscillates at a low operation voltage in fundamental transverse modes. For a laser device which oscillates in high-order transverse modes, noise caused by mode switching is reduced. Therefore, this surface emitting semiconductor laser device can be used as a light source for parallel data transmission and thus contributes to constructing a fast optical data communications system.

Further, the transverse modes of the laser device according to the present invention is controlled by the planar shape of the dielectric film (transparent layer) formed on the entire top surface, not by the size of the current constriction structure. This provides the design of the laser device with a higher degree of freedom and facilitates the fabrication, thus leading to a lower manufacturing cost.

## Claims

1. A surface emitting semiconductor laser device comprising:
a substrate (1);
a layer structure of a semiconductor material formed on a substrate and having a light-emitting layer (4) provided between an upper reflector layer structure (5) and a lower reflector layer structure (2);
an upper electrode (7a) having a planar shape of an annular ring formed above said upper reflector layer structure and having an opening portion defined inside; and
a transparent layer (8A) transparent to an oscillation wavelength of an oscillating laser beam and covering a part of a surface of said opening portion.

2. The surface emitting semiconductor laser device according to claim 1, wherein a planar shape of a light-emerging window (6A) for said oscillating laser beam is changed by changing a planar shape of said transparent layer.

3. The surface emitting semiconductor laser device according to claim 1 or 2, wherein a current feeding passage is formed in the vicinity of said light-emitting layer and a forming position of said transparent layer formed at said opening portion is included in a planar shape of said current feeding passage.

4. The surface emitting semiconductor laser device according to any one of claims 1 to 3, wherein said transparent layer is comprised of at least one layer of a dielectric film.

5. The surface emitting semiconductor laser device according to claim 4, wherein said dielectric film is formed of any one of silicon nitride, silicon oxide, aluminum oxide, titanium oxide, magnesium oxide and magnesium fluoride.

6. The surface emitting semiconductor laser device according to any one of claims 1 to 5, wherein a thickness of said transparent layer is equivalent to (2i + 1)/4n times an oscillation wavelength of said oscillating laser beam where n is a refractive index of said transparent layer and i is an integer.

7. The surface emitting semiconductor laser device according to any one of claims 1 to 5, wherein a thickness of said transparent layer is equivalent to 2i/4n times an oscillation wavelength of said oscillating laser beam where n is a refractive index of said transparent layer and i is a natural number, and a metal film is formed on said transparent layer.

## Patentansprüche

1. Eine oberflächenemittierende Halbleiterlaservorrichtung, die folgendes umfasst:
ein Substrat (1);
eine Schicht-Struktur eines Halbleitermaterials, die auf einem Substrat ausgebildet ist und eine lichtemittierende Schicht (4) besitzt, die zwischen einer oberen Reflektorschicht-Struktur (5) und einer unteren Reflektorschicht-Struktur (2) bereitgestellt wird;
eine obere Elektrode (7a) mit einer planaren Form eines kranzförmigen Rings, die oberhalb der oberen Reflektorschicht-Struktur ausgebildet ist und die einen innen bestimmten Öffnungsbereich besitzt; und
eine durchlässige Schicht (8A), die für eine Oszillations-Wellenlänge eines oszillierenden Laserstrahls durchlässig ist und einen Teil einer Oberfläche des Öffnungsbereichs bedeckt.

2. Die oberflächenemittierende Halbleiterlaservorrichtung gemäß Anspruch 1, worin eine planare Form eines Lichtaustrittsfensters (6A) für den oszillierenden Laserstrahl durch Verändern einer planaren Form der durchlässigen Schicht verändert wird.

3. Die oberflächenemittierende Halbleiterlaservorrichtung gemäß Anspruch 1 oder 2, worin ein Stromzuführungsweg in der Nähe der lichtemittierenden Schicht ausgebildet ist und eine Bildungsposition der durchlässigen Schicht, die an dem Öffnungsbereich ausgebildet ist, in einer planaren Form des Stromzuführungswegs eingeschlossen ist.

4. Die oberflächenemittierende Halbleiterlaservorrichtung gemäß irgendeinem der Ansprüche 1 bis 3, worin die durchlässige Schicht aus wenigstens einer Schicht eines dielektrischen Films besteht.

5. Die oberflächenemittierende Halbleiterlaservorrichtung gemäß Anspruch 4, worin der dielektrische Film aus irgendeinem aus Siliziumnitrid, Siliziumoxid, Aluminiumoxid, Titanoxid, Magnesiumoxid und Magnesiumfluorid gebildet wird.

6. Die oberflächenemittierende Halbleiterlaservorrichtung gemäß irgendeinem der Ansprüche 1 bis 5, worin eine Dicke der durchlässigen Schicht zum (2i+1)/4n-fachen einer Oszillations-Wellenlänge des oszillierenden Laserstrahls äquivalent ist, worin n ein Brechungsindex der durchlässigen Schicht und i eine ganze Zahl ist.

7. Die oberflächenemittierende Halbleiterlaservorrichtung gemäß irgendeinem der Ansprüche 1 bis 5, worin eine Dicke der durchlässigen Schicht zum 2i/4n-fachen einer Oszillations-Wellenlänge des oszillierenden Laserstrahls äquivalent ist, worin n ein Brechungsindex der durchlässigen Schicht und i eine natürliche Zahl ist, und worin ein Metall-Film auf der durchlässigen Schicht ausgebildet ist.

## Revendications

1. Un dispositif laser à semi-conducteur à émission par la surface, comprenant :
un substrat (1) ;
une structure à couches d'un matériau semi-conducteur formé sur un substrat et ayant une couche photoémettrice (4), placée entre une structure à couche réfléchissante supérieure (5) et une structure à couche réfléchissante inférieure (2) ;
une électrode supérieure (7a) ayant une forme plane de bague annulaire, formée au-dessus de ladite structure à couche réfléchissante supérieure et ayant une partie d'ouverture définie à l'intérieur de celle-ci ; et
une couche transparente (8A), transparente à une longueur d'ondes d'oscillation d'un faisceau laser oscillant et couvrant une partie d'une surface de ladite partie d'ouverture.

2. Le dispositif laser à semi-conducteur à émission par la surface selon la revendication 1, dans lequel une forme plane d'une fenêtre d'émergence de lumière (6A) pour ledit faisceau laser oscillant est modifiée par la modification d'une forme plane de ladite couche transparente.

3. Le dispositif laser à semi-conducteur à émission par la surface selon la revendication 1 ou 2, dans lequel un passage d'alimentation en courant est formé, à proximité de ladite couche photoémettrice, et une position de formage de ladite couche transparente, formée à ladite partie d'ouverture, est incluse dans une forme plane dudit passage d'alimentation en courant.

4. Le dispositif laser à semi-conducteur à émission par la surface selon l'une quelconque des revendications 1 à 3, dans lequel ladite couche transparente est formée d'au moins une couche d'un film diélectrique.

5. Le dispositif laser à semi-conducteur à émission par la surface selon la revendication 4, dans lequel ledit film diélectrique est formé d'un quelconque parmi le nitrure de silicium, l'oxyde de silicium, l'oxyde d'aluminium, l'oxyde de titane, l'oxyde de magnésium et le fluorure de magnésium.

6. Le dispositif laser à semi-conducteur à émission par la surface selon l'une quelconque des revendications 1 à 5, dans lequel une épaisseur de ladite couche transparente est équivalente à (2i+1)/4n fois une longueur d'ondes d'oscillation dudit faisceau laser oscillant, dans laquelle n est un indice de réfraction de ladite couche transparente et i est un entier.

7. Le dispositif laser à semi-conducteur à émission par la surface selon l'une quelconque des revendications 1 à 5, dans lequel une épaisseur de ladite couche transparente est équivalente à 2i/4n fois une longueur d'ondes d'oscillation dudit faisceau laser oscillant, dans laquelle n est un indice de réfraction de ladite couche transparente et i est un nombre naturel, et un film métallique est formé sur ladite couche transparente.
